# EUROPEAN PATENT APPLICATION

(11) **EP 1 376 234 A1**
(43) Date of publication of application: **02.01.2004**
(21) Application number: 02707112.5
(22) Date of filing: 20.03.2002
(51) Int. Cl.: G03F 7/075, G03F 7/40, H05K 3/18

(54) **METHOD FOR FORMING METAL PATTERN**

(30) Priority: 26.03.2001 JP 2001088155
(71) Applicant: Nippon Paint Co., Ltd., Osaka-shi, Osaka 531-8511 (JP)
(72) Inventor: TSUSHIMA, Hiroshi; c/o NIPPON PAINT CO., LTD., Neyagawa-shi, Osaka 572-8501 (JP)
(74) Representative: Merkle, Gebhard
(86) International application number: PCT/JP2002/002631
(87) International publication number: WO 2002/077713

(57) **Abstract**

A method for forming a metal pattern, characterized in that it comprises applying a photosensitive resin composition containing a polysilane having a weight average molecular weight of 10,000 or more and being soluble in an organic solvent, a photosensitive radical generating agent, an oxidizing agent, an alkoxy group-containing silicone compound and an organic solvent on a substrate, to form a photosensitive layer, exposing a region of the photosensitive layer corresponding with the metal pattern to a light, followed by developing, to thereby form a groove in the photosensitive layer, contacting the photosensitive layer with a solution containing a palladium salt or the like, to thereby allow an exposed part in the groove to absorb palladium or the like, contacting the photosensitive layer with an electroless plating solution, to thereby deposit a metal film on the part in the groove having absorbed palladium or the like and form the metal pattern.

## Description

### TECHNICAL FIELD

The present invention relates to a method for forming a metal pattern by utilizing polysilane.

### BACKGROUND ART

Polysilane is a very interesting polymer because it has metallic properties and delocalization of electrons due to the presence of silicon as compared to carbon, as well as having high heat resistance and good thin film-forming properties. Polysilane doped with iodine or ferric chloride is utilized to produce highly conductive materials.
Researches associated with the use of polysilane have been actively conducted in order to develop photoresists which enable formation of micropatterns with high precision (for example, Japanese Patent Laying-Open Nos. Hei 6-291273 and Hei 7-114188).

Japanese Patent Laying-Open No. Hei 5-72694 proposes a method for manufacture of a semiconductor integrated circuit by utilizing polysilane. This method uses a film of polysilane either alone or doped with iodine as a conductive layer. Also, a siloxane layer converted from polysilane by irradiation is used as an insulative layer.

However, insufficient conductivity of the polysilane conductive portion and susceptibility of iodine to corrosion have raised problems when the semiconductor integrated circuit obtained in accordance with the foregoing method is applied to electronic materials. Also because polysilane readily changes to siloxane when exposed to a moisture, oxygen or light in the ambient atmosphere, its use as a conductive material has been insufficient to assure reliability that is generally required for electronic materials.

Japanese Patent Laying-Open No. Sho 57-11339 describes a method for forming a metal image by exposing a compound having an Si-Si bond to radiation and then contacting it with a metal salt solution. This method utilizes reduction of the metal salt solution to a metal that occurs when the compound having an Si-Si bond is contacted with the metal solution, i.e., forms a metal layer on the unexposed area.

Japanese Patent Laying-Open No. Hei 10-326957 discloses a method for forming a metal pattern by exposing a film composed solely of polysilane to radiation, doping the exposed area with a palladium salt and performing electroless plating catalyzed by the palladium salt.

The polysilane film is generally highly crystalline, hard and brittle. The foregoing method accordingly results in the formation of a poorly adherent metal pattern and thus fails to form a practical metal pattern, which has been a problem.

Also, the metal pattern formed in accordance with the method for forming a metal pattern by electroless plating, as described in the above-identified reference, defines a raised portion since it is formed on a polysilane thin film. In the case where plural metal patterns are arranged in layers, such as in multilayer buildup circuit boards and multichip module boards, this requires practice of a planarizing treatment, e.g., filling portions outside the metal pattern using an insulating resin, which complicates a manufacturing process and thus makes the method impractical.

### DISCLOSURE OF THE INVENTION

It is an object of the present invention to provide a method for manufacture of a circuit board, which enables formation of a highly adherent and leveled metal pattern in a simple process.

The method of the present invention contemplates to form a metal pattern on a substrate and is characterized as including the steps of applying, to the substrate, a photosensitive resin composition containing polysilane soluble in an organic solvent and having a weight average molecular weight of 10,000 or higher, a photosensitive radical generator, an oxidizing agent, an alkoxy-containing silicone compound and an organic solvent to thereby provide a photosensitive layer; exposing a region of the photosensitive layer that corresponds to the metal pattern to a radiation and performing development thereof to thereby form, in the photosensitive layer, a channel portion that corresponds to the metal pattern; contacting the photosensitive layer with a liquid containing a salt or colloid of a metal having a lower standard electrode potential so that the metal having a lower standard electrode potential or the metal colloid is adsorbed in the channel portion; and contacting the photosensitive layer with an electroless plating liquid so that a film of a metal having a higher standard electrode potential is deposited in the channel portion where the metal having a lower standard electrode potential or the metal colloid has been adsorbed, thereby forming the metal pattern.

The photosensitive resin composition for use in the present invention contains polysilane. When polysilane is exposed to a radiation, such as an ultraviolet radiation, under the presence of oxygen, an Si-Si bond present therein is broken to produce an Si-OH group (silanol group). This silanol group, because of its weak acidic nature, can be dissolved in an aqueous alkaline solution or the like. Accordingly, development can be achieved by contacting the exposed portion with an aqueous alkaline solution or the like which dissolves away the exposed portion. In this invention, a region of the photosensitive layer that corresponds to the metal pattern is exposed to a radiation and developed to initially form therein the channel portion that corresponds to the metal pattern. The channel portion may extend through the photosensitive layer to the substrate.

If necessary, an inside of the channel portion of the photosensitive layer may be subsequently exposed to a radiation. This results in the production of silanol groups in the exposed portion in the channel portion. In the present invention, the inside of the channel portion in the photosensitive layer is not necessarily exposed twice to a radiation. In the present invention, the channel portion is formed as a result of removal of the exposed portion. However, the exposed portion may remain in the channel portion, although a little part thereof. This remaining part of the exposed portion can be utilized to adsorb the below-described metal having a lower standard electrode potential or the metal colloid and deposit the metal film.

Next, the photosensitive layer is contacted with a liquid containing a salt or colloid of a metal having a standard electrode potential lower than that of a metal which is later deposited in the channel portion, so that the metal having a lower standard electrode potential or the metal colloid is adsorbed at the exposed portion in the channel portion. The metal salt is reduced by silanol groups present in the exposed portion to metal which is subsequently adsorbed in the exposed portion. The metal colloid is adsorbed in the exposed portion without changing its form.

Next, the photosensitive layer is contacted with an electroless plating liquid. Then, a metal present in the electroless plating liquid is separated therefrom and deposited, in the form of a film, onto the exposed portion in the channel portion as if the metal having a lower standard electrode potential or the metal colloid functions as catalytic nuclei, so that a metal pattern is formed. In the present invention, the inside of the channel portion can be filled by depositing, in the form of a film, the metal in the channel portion in the manner as described above.

The metal pattern formed in accordance with the present invention can be embedded in the channel portion, as described above. In such a case, a top surface of the metal pattern can be conformed in level to a surface of the surrounding portion, so that a metal pattern having a planarized surface can be formed. Therefore, even in the case where plural metal circuit patterns are arranged in layers, such as in multilayer buildup boards, the need of a planarizing treatment is eliminated. This enables fabrication of multilayer buildup circuit boards in a simplified process.

However, the metal pattern formed in the present invention is not necessarily limited to the configuration wherein the metal film is embedded in the channel portion. In an exemplary case where the channel portion extends through the photosensitive layer to the substrate, the metal film may be formed on a side wall of the channel portion to provide a film-covered inner wall which defines a through-hole.

Also, the photosensitive resin composition for use in the present invention contains an alkoxy-containing silicone compound. This alkoxy-containing silicone compound contains at least two alkoxy groups per molecule. When it is heated, the alkoxy group decomposes to produce an Si-OH group (silanol group). As this silanol group is reactive with polysilane, the alkoxy-containing compound can be crosslinked with polysilane by heating the coated film, thereby improving adherence of the coated film. Accordingly, the metal pattern formed in the channel portion of the photosensitive layer by electroless plating in accordance with the present invention has good adherence to the surrounding photosensitive layer. Therefore, in accordance with the present invention, a finely defined and highly adherent metal pattern can be formed and thus metal patterns widely applicable for uses in electrical, electronic and communication areas can be produced in an inexpensive and simple process.

Subsequent to formation of a metal pattern by electroless plating, the photosensitive layer bearing the metal pattern thereon is preferably heated in order to promote crosslinking of the silicone compound with polysilane. In this instance, the heating temperature is preferably in the approximate range of 150 - 250 °C. The heating time is generally 5 minutes - 60 minutes, although it is suitably adjusted depending on the heating temperature.

In the present invention, particularly preferred for use as the alkoxy-containing compound is a silicone compound having a structure represented by the following general formula: 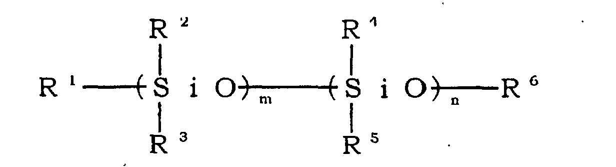 (In the formula, R¹, R², R³, R⁴, R⁵ and R⁶ are independently a functional group selected from the group consisting of an aliphatic hydrocarbon group having a carbon number of 1 - 10, either substituted or unsubstituted with halogen or a glycidyl group, an aromatic hydrocarbon group having a carbon number of 6 - 12, either substituted or unsubstituted with halogen, and an alkoxy group having a carbon number of 1 - 8; they may be identical or different from each other, provided that the silicone compound contains at least two of the aforementioned alkoxy groups per molecule; and m and n are both integers and satisfy m + n ≧ 1.).

The present invention enables formation of a metal pattern having a planarized surface, as described above, and is a method suitable for fabrication of a metal circuit pattern such as in multilayer buildup circuit boards. Specifically, a metal circuit pattern is first formed in accordance with the present invention. Secondly, the aforesaid photosensitive resin composition is coated thereon to provide a photosensitive layer. Then, the above process is repeated to form another metal pattern. By repeating these processes several times, a multilayer circuit board can be fabricated including plural superimposed metal circuit patterns.

The electroless plating liquid for use in the present invention preferably contains a metal ion, such as of copper, nickel, palladium, gold, platinum or rhodium, which forms the aforementioned metal film when deposited.

### BRIEF DESCRIPTION OF THE DRAWINGS

Figure 1 is a schematic sectional view, showing one example of a metal pattern forming process in accordance with the present invention; and
Figure 2 is a schematic sectional view, showing one example of a metal pattern forming process in accordance with the present invention.

### BEST MODE FOR CARRYING OUT THE INVENTION

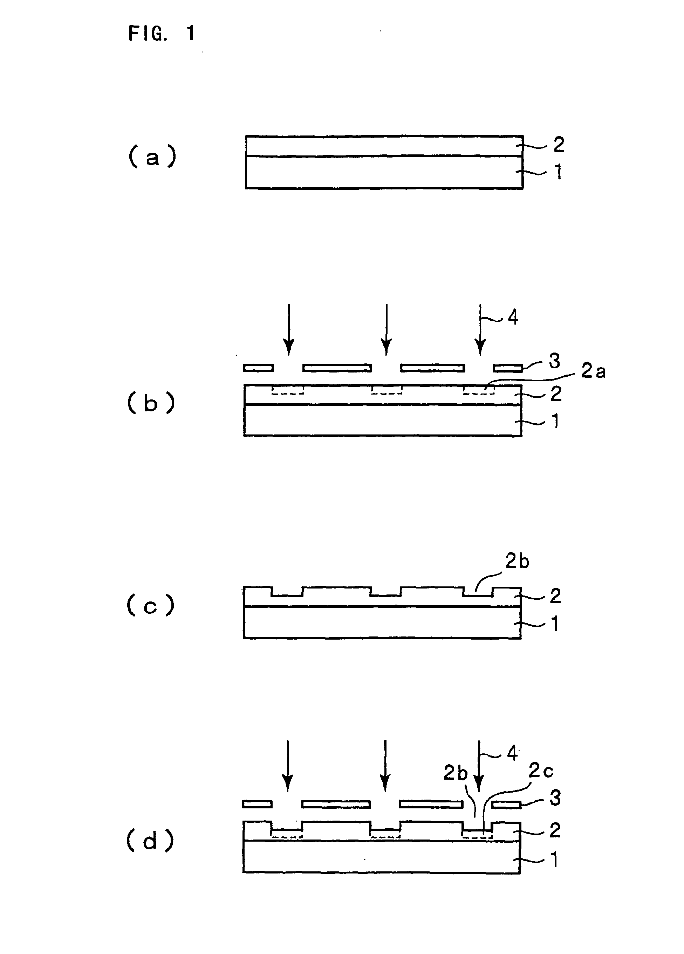

Figure 1 is a schematic sectional view which explains a method for forming a metal pattern in accordance with the present invention.

As shown in Figure 1(a), a photosensitive resin composition of the present invention is first applied onto a substrate 1 to provide a photosensitive layer 2 thereon.

As shown in Figure 1(b), a mask 3 is then positioned above the photosensitive layer 2 which is subsequently exposed to an ultraviolet radiation 4 through the mask 3 so that selective exposure of the photosensitive layer 2 is effected. The mask 3 is patterned such that a radiation passes through its area that corresponds to a metal pattern which is later formed. Accordingly, the photosensitive layer 2 is subjected to a radiation in its area that corresponds to a metal pattern which is later formed, so that an exposed portion 2a is formed therein. Here, a mask is utilized to achieve selective exposure of the photosensitive layer. However, the present invention is not limited thereto. For example, selective exposure may be achieved by scanning a laser beam.

In the exposed portion 2a, polysilane is exposed to an ultraviolet radiation under the presence of oxygen. This causes breakage of an Si-Si bond to produce an Si-OH group (silanol group).

Next, an aqueous alkaline solution or the like is brought into contact with the photosensitive layer 2 to dissolve away the exposed portion 2a and form a channel portion 2b, as shown in Figure 1 (c). Since this channel portion 2b appears after the exposed portion 2a is dissolved away, it is formed in the area of the photosensitive layer that corresponds to a metal pattern which is later formed.

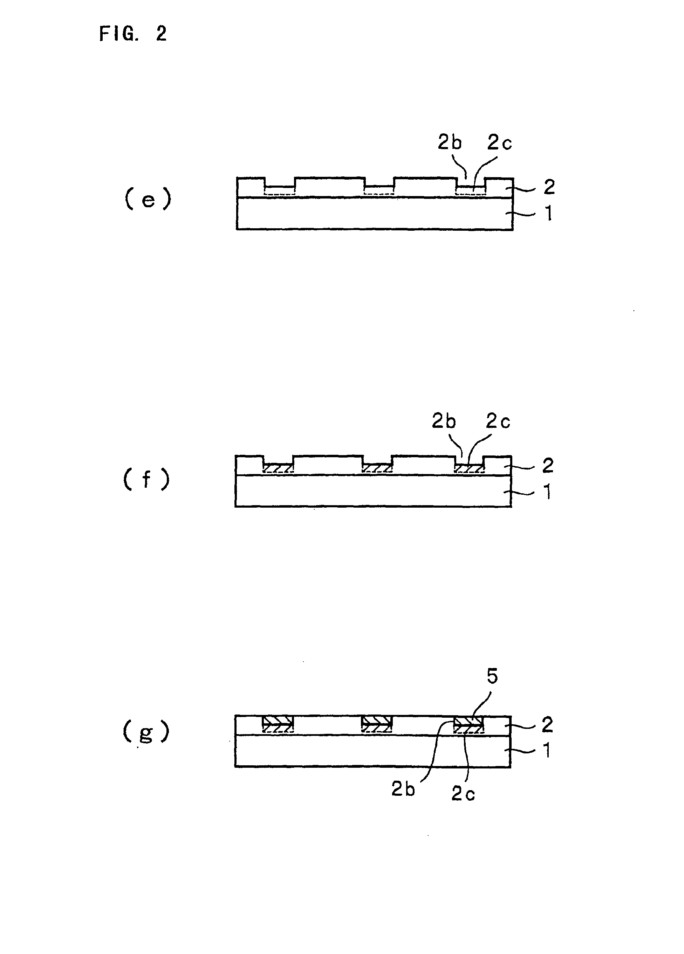

Again, a mask 3 is positioned above the photosensitive layer 2, as shown in Figure 1(d). The mask 3 may be similar to that used in the process shown in Figure 1(b). This mask 3 has an open pattern which corresponds to a metal pattern that is to be formed. The mask 3 is accordingly positioned such that its open pattern is brought into register with the channel portion 2b of the photosensitive layer 2. By this arrangement, an inside of the channel portion 2b can be exposed to an ultraviolet radiation 4. As a result, an exposed portion 2c can be formed in the channel portion 2b of the photosensitive layer 2, as shown in Figure 2(e).

Next, a liquid containing a salt of a metal having a low standard electrode potential, e.g., a liquid containing a palladium salt, is brought into contact with the photosensitive layer 2 for adsorption of palladium in the exposed portion 2c of the channel portion 2b, as shown in Figure 2(f). The palladium salt, when contacted with the exposed portion 2c where silanol groups have been produced, is chemically reduced to metallic particles of palladium which are subsequently adsorbed in the exposed portion 2c. On the other hand, such metallic particles of palladium are not produced in areas outside the exposed portion 2c, where the palladium salt can be readily removed by washing. Therefore, palladium is allowed to adsorb only in the exposed portion 2c. Also in the case where the metal colloid is used, it is possible to allow the metal colloid to selectively adsorb only in the exposed portion 2c.

As shown in Figure 2(g), an electroless plating liquid is then brought into contact with the photosensitive layer 2 to deposit a metal film 5 on the exposed portion 2c where palladium has been adsorbed. When the electroless plating liquid contacts with the palladium-adsorbed exposed portion 2c, the metal present in the plating liquid is separated and deposited thereon as if the metallic particles of palladium function as catalytic nuclei. As a result,' the metal film 5 is selectively deposited only on the exposed portion 2c. Since the exposed portion 2a exists in the inside of the channel portion 2b, the metal film 5 is deposited in a manner to fill the channel portion 2b. Also since the exposed portion 2c corresponds in shape to a metal pattern to be formed, the metal film 5 deposited in the channel portion 2b defines the metal pattern.

As a result, the metal pattern is formed having a planarized surface, as shown in Figure 2(g). The subsequent heating, if applied, causes crosslinking of a resin in the photosensitive layer 2, resulting in the improved adhesion of the metal film 5.

As described earlier, the process shown in Figure 1(d) is not necessarily practiced in this invention. That is, there is an occasion where the exposed portion remains in the channel portion 2b. In such an occasion, palladium or the like can be brought to adsorb in this exposed portion.

The channel portion 2b may be configured to extend through the photosensitive layer 2 to the substrate 1. Also, the metal film 5 is not necessarily deposited to fill the channel portion 2b. As described above, the metal film may be deposited on a side wall of the channel portion 2b to provide a film-deposited inner wall which defines a through-hole. In this case, the exposed portion remaining in the side wall of the channel portion 2b may be utilized. Alternatively, the side wall of the channel portion 2b may be exposed anew to a radiation to provide an exposed portion which may be utilized.

The photosensitive resin composition, the liquid containing a salt or colloid of a metal having a low standard electrode potential (hereinafter referred to simply as "metal salt containing liquid") and the electroless plating liquid , respectively for use in the present invention, will be now described.

### (PHOTOSENSITIVE RESIN COMPOSITION)

The photosensitive resin composition for use in the present invention contains polysilane soluble in an organic solvent and having a weight average molecular weight of at least 10,000, a photosensitive radical generator, an oxidizing agent, an alkoxy-containing silicone compound (hereinafter referred to as simply "silicone compound") and an organic solvent. These components are described below.

### (Polysilane)

Network and straight-chain polysilanes can be used in the present invention. The use of network polysilane is preferred, if a mechanical strength as a photosensitive material is considered. Network and straight-chain polysilanes are distinguished from each other by a bonding state of an Si atom contained in polysilane. The network polysilane refers to polysilane containing an Si atom with the number of bonds (binding number) to neighboring Si atoms being 3 or 4. On the other hand, the straight-chain polysilane contains an Si atom with the number of bonds to neighboring Si atoms being 2. Since the Si atom normally has a valence of 4, the Si atom having the binding number of 3 or less, if present among Si atoms in polysilane, is bound to a hydrocarbon group, an alkoxy group or a hydrogen atom, as well as to neighboring Si atoms. The preferred hydrocarbon group is an aliphatic hydrocarbon group having a carbon number of 1 - 10, either substituted or unsubstituted with halogen, or an aromatic hydrocarbon group having a carbon number of 6 - 14.

Specific examples of aliphatic hydrocarbon groups include chain hydrocarbon groups such as methyl, propyl, butyl, hexyl, octyl, decyl, trifluoropropyl and nonafluorohexyl groups; and alicyclic hydrocarbon groups such as cyclohexyl and methylcyclohexyl groups.

Specific examples of aromatic hydrocarbon groups include phenyl, p-tolyl, biphenyl and anthracyl groups. The alkoxy group may have a carbon number of 1 - 8. Examples of such alkoxy groups include methoxy, ethoxy, phenoxy and octyloxy groups. If easy synthesis is considered, methyl and phenyl groups are particularly preferred among these.

In the case of network polysilane, it preferably contains 2 - 50 % of Si atoms with the number of bonds to neighboring Si atoms being 3 or 4, based on a total number of Si atoms present in the' network polysilane. This value can be determined by measuring a nuclear magnetic resonance spectrum for silicon.

Polysilane, as referred to in this specification, also encompasses a mixture of network and straight-chain polysilanes. In such a case, the content of the aforementioned Si atoms is calculated from a mean value of those of network polysilane and straight-chain polysilane.

Polysilane for use in the present invention can be produced by a polycondensation reaction that occurs when a halogenated silane compound in an organic solvent such as n-decane or toluene is heated under the presence of an alkaline metal such as sodium to a temperature of 80 °C or above.

Network polysilane can be obtained, for example, by polycondensation that occurs when a halosilane mixture is heated which contains an organotrihalosilane compound, a tetrahalosilane compound and a diorganodihalosilane compound, wherein the organotrihalosilane and tetrahalosilane compounds are present in the amount of below 50 mole % but not below 2 mole %, based on the total amount of the halosilane mixture. Here, the organotrihalosilane compound serves as a source of Si atoms with the number of bonds to neighboring Si atoms being 3, and the tetrahalosilane compound serves as a source of Si atoms with the number of bonds to neighboring Si atoms being 4. The network structure can be identified by measuring an ultraviolet absorption spectrum or a nuclear magnetic resonance spectrum for silicon.

Straight-chain polysilane can be produced by the similar reaction utilized in the production of network polysilane, except that diorganodichlorosilanes, either alone or in combination, are used.

Preferably, the respective halogen atoms in the foregoing organotrihalosilane compound, tetrahalosilane compound and diorganodihalosilane compound, for use as the raw material of polysilane, are chlorine atoms. Besides such halogen atoms, the organotrihalosilane and diorganodihalosilane compounds have a substituent group, examples of which include the above-listed hydrocarbon and alkoxy groups and a hydrogen atom.

These network and straight-chain polysilanes are not particularly specified in type, so long as they are soluble in an organic solvent and have weight average molecular weights of 10,000 and above. In view of its utility as a photosensitive material, polysilane for use in the present invention is preferably soluble in a volatile organic solvent. Examples of such organic solvents include those based on hydrocarbons having carbon numbers of 5 - 12, halogenated hydrocarbons and ethers.

Examples of hydrocarbon-based organic solvents include pentane, hexane, heptane, cyclohexane, n-decane, n-dodecane, benzene, toluene, xylene and methoxybenzene. Examples of halogenated hydrocarbon-based organic solvents include carbon tetrachloride, chloroform, 1,2-dichloroethane, dichloro-methane and chlorobenzene. Examples of ether-based organic solvents include diethyl ether, dibutyl ether and tetrahydrofuran.

Polysilane for use in the present invention has a weight average molecular weight of 10,000 or above. If its weight average molecular weight is below 10,000, polysilane may show insufficient film properties such as chemical resistance and heat resistance. Polysilane preferably has a weight average molecular weight of 10,000 - 50,000, more preferably of 15,000 - 30,000.

### (Photosensitive radical generator and oxidizing agent)

The photosensitive radical generator for use in the present invention is not particularly specified, so long as it is capable of generating halogen radicals when irradiated. Examples of such photosensitive radical generators include 2,4,6-tris(trihalomethyl)-1,3,5-triazine and its derivatives substituted either at the 2-position thereof or at the 2-and 4-positions thereof; phthalimidetrihalomethane sulfonate and its derivatives having a substituent attached to a benzene ring thereof; naphthalimidetrihalomethane sulfonate and its derivatives having a substituent attached to a benzene ring thereof; and the like. The substituents of these compounds are aliphatic and aromatic hydrocarbon groups which may also have a substituent.

The oxidizing agent for use in the present invention is not particularly specified, so long as it can be a source of oxygen supply. Examples of oxidizing agents include peroxides, amine oxides and phosphine oxides.

A trichlorotriazine-based photosensitive radical generator and a peroxide oxidizing agent constitute the particularly preferred combination of the photosensitive radical generator and oxidizing agent.

The purpose of adding the photosensitive radical generator is to achieve effective breakage of Si-Si bonds by halogen radicals when the aforementioned polysilane decomposes upon exposure to a radiation. The purpose of adding the oxidizing agent is to facilitate insertion of oxygen to the bond of Si after breakage.

A soluble dye such as coumarin, cyanine or merocyanine dye may be added to promote generation of halogen radicals by optical excitation of such a dye. Addition of the soluble dye also increases the sensitivity of polysilane to a radiation.

### (Silicone compound)

The silicone compound for use in the present invention is a silicone compound which contains at least two alkoxy groups per molecule. Preferably used is a silicone compound having a structure represented by the following general formula: 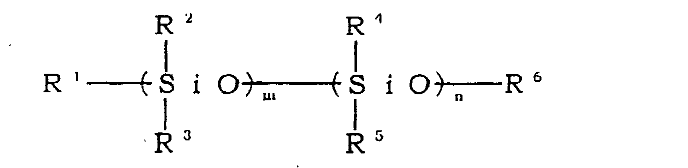 ( In the formula, R¹, R², R³, R⁴, R⁵ and R⁶ are independently a group selected from the group consisting of an aliphatic hydrocarbon group having a carbon number of-10, either substituted or unsubstituted with halogen or a glycidyl group, an aromatic hydrocarbon group having a carbon number of 6 - 12, either substituted or unsubstituted with halogen, and an alkoxy group having a carbon number of 1 - 8; they may be identical or different from each other, provided that the silicone compound contains at least two of the aforementioned alkoxy groups per molecule; and m and n are both integers and satisfy m + n ≧ 1.).

Specific examples of aliphatic hydrocarbon groups which can be selected for the preceding substituents R¹ - R⁶ include chain hydrocarbon groups such as methyl, propyl, butyl, hexyl, octyl, decyl, trifluoropropyl and glycidyloxypropyl groups; and alicyclic hydrocarbon groups such as cyclohexyl and methylcyclohexyl groups. Specific examples of aromatic hydrocarbon groups include phenyl, p-tolyl and biphenyl groups. Examples of alkoxy groups include methoxy, ethoxy, phenoxy, octyloxy and ter-butoxy groups.

The types of the preceding R¹ - R⁶ and the values of m and n are not very important and accordingly not particularly specified, so long as the silicone compound is compatible with polysilane and the organic solvent. If the compatibility is of concern, the silicone compound preferably has the same hydrocarbon group as contained in polysilane used. For example, in the case where phenylmethyl-based polysilane is used, the use of a phenylmethyl- or diphenyl-based silicone compound is preferred.

In the silicone compound for use in the present invention, at least two of R¹ - R⁶ in a molecule are alkoxy groups having carbon numbers of 1 - 8. Due to the inclusion of at least two alkoxy groups per molecule, the silicone compound serves as a crosslinking agent for polysilane. Such silicone compounds can be illustrated by methylphenylmethoxy silicone and phenylmethoxy silicone, each having an alkoxy group content by weight of 15 - 35 %.

The silicone compound for use in the present invention preferably has a weight average molecular weight of 10,000 or below, more preferably 3,000 or below. If the weight average molecular weight of the silicone compound becomes excessively high, its compatibility with polysilane may decrease to result in the heterogeneous film and the reduced sensitivity.

### (Organic solvent)

The organic solvent for including in the photosensitive resin composition in the present invention is not particularly specified, so long as it has the capability to solubilize polysilane. Specifically, those organic solvents exemplified in the description of polysilane can be used.

### (Formulation of photosensitive resin composition)

The photosensitive resin composition for use in the present invention preferably contains 1 - 30 parts by weight of a photosensitive radical generator, 1 - 30 parts by weight of an oxidizing agent and 5 - 100 parts by weight of a silicone compound, based on 100 parts by weight of polysilane. The aforementioned soluble dye, if added, is preferably present in the amount of 1 - 20 parts by weight, based on 100 parts by weight of polysilane. The organic solvent is preferably incorporated in the concentration of 20 - 99 % by weight, based on the total weight of the composition.

The silicone compound serves as a crosslinking agent for polysilane, increases solubility of polysilane to the organic solvent and functions as an agent which renders polysilane compatible with the photosensitive radical generator and the oxidizing agent. The use of the silicone compound thus allows the composition to contain larger amounts of photosensitive radical generator and oxidizing agent.

### (Application method of photosensitive resin composition)

The application method of the photosensitive resin composition is not particularly specified. The photosensitive layer can be provided by various application methods, including spin coating, dipping, casting, vacuum deposition and an LB technique (Langmuir-Blodgett technique). The use of a spin coating technique is particularly preferred which achieves application by spreading the photosensitive resin composition on a substrate and spinning the substrate at a high rate.

In the case where the spin coating technique is utilized to provide the photosensitive layer, the preferred organic solvents for use in the photosensitive resin composition include aromatic hydrocarbons such as benzene, toluene and xylene and ethers such as tetrahydrofuran and dibutyl ether. The organic solvent is preferably used in such an amount that keeps a solids concentration within 1-20 % by weight, i.e., in such an amount that keeps an organic solvent content within 80 - 99 % by weight.

The photosensitive layer is deposited on the substrate to a thickness preferably of 0.01 - 1,000 µm, more preferably of 0.1 - 50 µm.

### (Exposure of photosensitive layer)

An ultraviolet radiation is preferably utilized to irradiate the photosensitive layer. Useful sources of an ultraviolet radiation include continuous spectrum radiation sources such as hydrogen discharge tubes, noble gas discharge tubes, tungsten lamps and halogen lamps; and discontinuous spectrum radiation sources such as various lasers and mercury lamps. Useful lasers include He-Cd laser, Ar laser, YAG laser and excimer laser. Mercury lamps, among them, are preferably used as the radiation source because they are inexpensive and easy to handle.

Preferably, the radiation source emits an ultraviolet radiation in the wavelength range of 250 - 400 nm which corresponds to a σ-σ* absorption range of polysilane. The amount of exposure is preferably 0.1 - 10 J/cm², more preferably 0.1 - 1 J/cm², per µm thickness of the photosensitive layer.

### (Development of Photosensitive Layer)

As described above, a silanol group is generated in the exposed portion of the photosensitive layer. Since this silanol group shows a weak acidic nature, the photosensitive layer can be developed by utilizing an aqueous alkaline solution or the like which dissolves away the exposed portion. Examples of useful aqueous alkaline solutions include aqueous solutions of amines such as tetramethylammonium hydroxide (TMAH); and aqueous solutions of inorganic bases such as sodium hydroxide. Particularly preferred is a 1.0 - 5.0 wt.% aqueous solution of TMAH. An alcoholic solvent may be added to this aqueous solution for the purpose of causing the exposed portion of the photosensitive layer to swell.

### (SUBSTRATE)

The substrate is not particularly specified and can be chosen from various types of substrates depending upon the contemplated use. Examples of useful substrates include insulator substrates such as composed of quartz glass and ceramics, semiconductor substrates such as of silicon, and conductor substrates such as of aluminum.

### (METAL SALT CONTAINING LIQUID)

The metal salt containing liquid as referred to in the present invention is a solution which contains a salt or colloid of a metal that has a low standard electrode potential. The metal salt containing solution is not particularly specified, so long as it contains a metal salt useful for pretreatment of an electroless plating liquid. Generally, a solution is often employed which contains a noble metal, such as gold, silver, platinum or palladium, in the form of a metal salt. These metal salt containing solutions serve as catalyst carriers and are readily available at low costs. A solution containing a silver or palladium salt as a catalyst is often used. A metal salt compound can be generally represented by the form of A-Zₙ (n is a valence of A), wherein A denotes a metal. Z is illustrated by a halogen atom such as Cl, Br or I, acetate, trifluoroacetate, acetylacetonato, carbonate, perchlorate, nitrate, sulfonate, oxide or the like. Examples of palladium salt compounds include PdCl₂, PdBr₂, PdI₂, Pd(OCOCH₃)₂, Pd(OCOCF₃)₂, PdSO₄, Pd(NO₃)₂ and PdO.

A useful example of the metal colloid containing solution is a colloidal solution of a noble metal such as disclosed in Japanese Patent Laying-Open No. Hei 11-80647.

The metal salt containing liquid is a solution in which the aforementioned metal salt or metal colloid is dissolved or dispersed. Preferably, a solvent is used which dissolves or disperses a metal salt or metal colloid but does not dissolve polysilane. Although difficult to specify suitable solvents unconditionally as solubility of polysilane varies depending upon the types of pendant groups, the degree of polymerization or the like, the followings may be generally preferably used: water; ketones such as acetone and methyl ethyl ketone; esters such as ethyl acetate; alcohols such as methanol and ethanol; aprotic polar solvents such as dimethylformamide, dimethyl sulfoxide and hexamethylphosphoric triamide; nitromethane; acetonitrile; and the like. If polysilane is used in the form of phenylmethylpolysilane, the use of alcohols such as methanol is particularly preferred. The solvent is used such that a concentration of palladium salt is preferably kept within 0.1 - 20 % by weight, more preferably 1 - 10 % by weight.

Preferably, the photosensitive layer on the substrate is brought into contact with the metal salt containing liquid by immersing the substrate bearing the photosensitive layer in the metal salt containing liquid. The immersion time is not particularly specified but may be in the approximate range of 1 second - 10 minutes, for example. After immersion, drying is carried out generally at a temperature of 10 °C - 200 °C under ambient or reduced pressure.

As described earlier, the exposed portion where the latent image has been formed is rendered hydrophilic due to production of silanol groups. In this portion, the metal salt is accordingly reduced to metal particles for adsorption. When the metal salt containing liquid is brought into contact with the photosensitive layer, the liquid temperature may be raised to 40 - 200 °C in order to promote reduction of the metal salt to metal particles.

The metal colloid, if applied, is adsorbed, in the form of existing metal colloid, in the exposed portion.

The metal salt containing liquid may further contain ions of one or more metals other than the aforementioned metal. An example of the other metal is tin. These metals, if alloyable with the aforementioned metal, are deposited in the form of alloy particles thereof and adsorbed.

### (ELECTROLESS PLATING LIQUID)

An electroless plating liquid is preferably used which contains a metal ion such as of copper, nickel, palladium, gold, platinum or rhodium. The electroless plating liquid generally contains a water-soluble metal salt of any of the preceding metals, a reducing agent such as sodium hypophosphite, hydrazine or sodium boron hydride and a complexing agent such as sodium acetate, phenylenediamine or potassium sodium tartrate. In general, such electroless plating liquids are readily available in the market at low costs.

Preferably, the photosensitive layer is brought into contact with the electroless plating liquid in the same manner as used to bring it into contact with the aforementioned liquid containing a palladium salt, i.e., by immersing the substrate bearing the photosensitive layer in the electroless plating liquid. When the electroless plating liquid is brought into contact with the photosensitive layer, the liquid is preferably maintained at a temperature of 15 - 120 °C, more preferably 25 - 85 °C. The contact time is 1 minute - 16 hours, for example, and preferably in the approximate range of 10 - 60 minutes.

Preferably, a metal film is deposited by the electroless plating liquid to such a thickness that fills the channel portion of the photosensitive layer. This results in the formation of a metal circuit pattern having a planarized surface. The thickness of the metal film and the depth of the channel portion are generally about 0.01 - 100 µm, further about 0.1 - 20 µm.

In accordance with the present invention, a highly adherent and leveled metal pattern can be formed in a simplified process.

The present invention is below described in more detail by way of Examples. It will be recognized that the following examples merely illustrate the practice of the present invention but are not intended to be limiting thereof. Suitable changes and modifications can be effected without departing from the scope of the present invention.

### (PREPARATION EXAMPLE 1)

### (Preparation of Polysilane)

400 ml of toluene and 13.3 g of sodium were charged into a 1,000 ml flask equipped with a stirrer. The flask contents were heated in a UV-shielded yellow room to a temperature of 111 °C and then stirred at a high speed to provide a fine dispersion of sodium in toluene. 42.1 g of phenylmethyl-dichlorosilane and 4.1 g of tetrachlorosilane were added to the dispersion which was then stirred to effect polymerization. Thereafter, ethanol was added to the resulting reaction mixture to deactivate excess sodium. The mixture was then washed with water and then subjected to separation. The separated organic layer was introduced into ethanol to precipitate polysilane. This crude polysilane was reprecipitated with ethanol three times to obtain network polymethylphenylsilane having a weight average molecular weight of 11,600.

### (EXAPLE 1)

100 parts by weight of network polysilane obtained in the Preparation Example 1, 50 parts by weight of TSR-165 (methylphenylmethoxy silicone resin with a molecular weight of 930, methoxy group content: 15 weight %, product of Toshiba Silicone Co., Ltd.) as a silicone compound, 10 parts by weight of TAZ-110 (2,4-bis(trichloromethyl)-6-(p-methoxyphenyl-vinyl)-1,3,5-triazine, product of Midori Kagaku Co., Ltd.) as a photosensitive radical generator, and 15 parts by weight of BTTB (3,3',4,4'-tetra-(t-butylperoxycarbonyl)benzophenone, product of NOF Corp.) as an oxidizing agent were dissolved in 1215 parts by weight of toluene to obtain a photosensitive resin composition. This photosensitive resin composition was coated on a glass substrate using a spin coater to a thickness of 20 µm and dried in an oven at 120 °C for 10 minutes to provide a photosensitive layer on the glass substrate.

Next, a photomask was placed above the photosensitive layer which was subsequently exposed, through the photomask, to an ultraviolet radiation of 365 nm wavelength at radiation energy of 500 mJ/cm² using a 500 W mercury lamp to achieve exposure of the photosensitive layer in a predetermined pattern and thereby provide an exposed portion which corresponded in shape to a metal circuit pattern.

Next, the photosensitive layer, together with the substrate, were immersed in a TMAH solution containing 20 % isopropanol. They were immersed in the solution at 23 °C for 5 minutes, washed with pure water, and then dried at 100 °C for 10 minutes. The exposed portion of the photosensitive layer was removed via this immersion, resulting in the formation of a channel portion which conformed in shape to the metal circuit pattern. The depth of this channel portion was measured by a stylus profilometer DekTak 3ST which gave a value of 10.5 µm.

Next, a photomask similar to the preceding photomask was again placed above the photosensitive layer. This photomask was placed in the same position as the preceding photomask so that an open pattern of the photomask was brought into register with the channel portion defined in the photosensitive layer. The inside of the channel portion of the photosensitive layer was exposed to an ultraviolet radiation of 365 nm wavelength at radiation energy of 500 mJ/cm², using a 500 W mercury lamp, to thereby form an exposed portion in the channel portion.

Next, the photosensitive layer, together with the substrate, were immersed in a 5 wt.% ethanol solution of palladium chloride-tin chloride for 5 minutes, subsequent to immersion, washed with ethanol and then dried at 100 °C for 10 minutes. This resulted in the adsorption of palladium tin in the exposed portion of the channel portion.

Next, the photosensitive layer, together with the substrate, were immersed in an electroless plating liquid at 50 °C for 30 minutes. The electroless plating liquid consisted of 10 g of copper sulfate, 2 g of 37 % formalin, 10 g of sodium hydroxide and 1,000 g of water. This resulted in the deposition of a metal film, composed of copper, on the exposed portion in the channel portion of the photosensitive layer and accordingly in the formation of the metal circuit pattern in the channel portion. The metal film was measured to be 10 µm thick.

The photosensitive layer with the metal circuit pattern was washed with pure water and then heat dried at 150 °C for 30 minutes. The metal circuit pattern was measured as having an electrical conductivity of 7 x 10⁵ S/cm. Adhesion of the metal circuit pattern was evaluated by measuring its peel strength. Measurement revealed a peel strength of at least 0.9 kgf/cm, whereby good adherence of the metal circuit pattern was confirmed.

### (EXAMPLE 2)

The procedure of Example 1 was followed to prepare a photosensitive resin composition and coat it on a substrate to provide a photosensitive layer. This photosensitive layer was exposed to an ultraviolet radiation and developed in the same manner as in Example 1 to thereby form a channel portion which corresponded to a metal circuit pattern. Subsequently, the substrate carrying the photosensitive layer was immersed in a 5 wt.% palladium chloride solution in ethanol for 5 minutes, taken out from the solution, washed with ethanol and then dried at 100 °C for 10 minutes. This resulted in the adsorption of palladium in the exposed portion of the channel portion. The depth of the channel portion was found to be 11.0 µm.

Next, the substrate carrying the photosensitive layer was immersed in an electroless plating liquid at 50 °C for 30 minutes. The electroless plating liquid consisted of 20 g of nickel chloride, 10 g of sodium hypophosphite, 30 g of sodium acetate and 1,000 g of water. This resulted in the deposition of a metal film, composed of nickel, on the exposed portion in the channel portion and accordingly in the formation of the metal circuit pattern in the channel portion. The metal film was found to be 10 µm thick.

The photosensitive layer having the metal circuit pattern defined therein was washed with pure water and then heat dried at 150 °C for 30 minutes. The metal circuit pattern was measured as having an electrical conductivity of 7 x 10³ S/cm. Adhesion of the metal circuit pattern was evaluated by measuring its peel strength. Measurement revealed a peel strength of at least 0.7 kgf/cm, whereby good adherence of the metal circuit pattern was confirmed.

As described above, the present invention contemplates to form a metal circuit pattern by depositing, in the form of a film, a metal in the channel portion. Therefore, a metal circuit pattern having a planarized surface can be formed.

In the preceding Examples, the metal circuit pattern is described as one exemplary form of the metal pattern. However, the present invention is not limited to formation of a metal pattern for circuit use. The present invention is also applicable for formation of metal patterns for uses other than circuit use.

### UTILITY IN INDUSTRY

In accordance with the present invention, a highly adherent and leveled metal pattern can be formed in a simple process. Therefore, the present invention are very useful in forming circuits such as of multilayer buildup circuit boards and multichip module boards. Also, the present invention can be utilized to form metal patterns in various applications, including miniature heating elements, battery electrodes, solar batteries, sensors, integrated circuits and casings for miniature motors. Therefore, the present invention is useful in forming metal patterns in a wide variety of applications as in electrical, electronic and communication areas.

## Claims

1. A method of forming a metal pattern on a substrate **characterized** as including the steps of:
applying, to the substrate, a photosensitive resin composition containing polysilane soluble in an organic solvent and having a weight average molecular weight of 10,000 or higher, a photosensitive radical generator, an oxidizing agent, an alkoxy-containing silicone compound and an organic solvent to thereby provide a photosensitive layer;
exposing a region of said photosensitive layer that corresponds to the metal pattern to a radiation and subsequently performing development thereof to form, in the photosensitive layer, a channel portion that corresponds to the metal pattern;
contacting the photosensitive layer with a liquid containing a salt or colloid of a metal having a lower standard electrode potential so that said metal having a lower standard electrode potential or said metal colloid is adsorbed in said channel portion; and
contacting the photosensitive layer with an electroless plating liquid so that a film of a metal having a higher standard electrode potential is deposited in the channel portion where the metal having a lower standard electrode potential or the metal colloid has been adsorbed, thereby forming the metal pattern.

2. The method for forming a metal pattern as recited in claim 1, **characterized in that** said metal film is deposited in said channel portion so as to fill an inside of the channel portion.

3. The method for forming a metal pattern as recited in claim 1 or 2, **characterized** as further including the step of exposing an inside of said channel portion in the photosensitive layer, before the photosensitive layer is contacted with said liquid containing a salt or colloid of a metal having a lower standard electrode potential.

4. The method for forming a metal pattern as recited in any one of claims 1 - 3, **characterized in that** said alkoxy-containing silicone compound is a silicone compound having a structure represented by the following general formula: 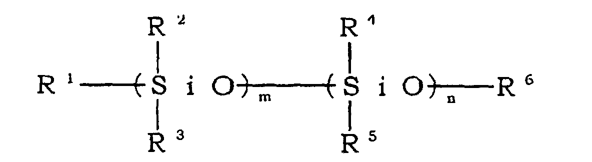 (in the formula, R¹, R², R³, R⁴, R⁵ and R⁶ are independently a group selected from the group consisting of an aliphatic hydrocarbon group having a carbon number of 1-10, either substituted or unsubstituted with halogen or a glycidyl group, an aromatic hydrocarbon group having a carbon number of 6 - 12, either substituted or unsubstituted with halogen, and an alkoxy group having a carbon number of 1 - 8; they may be identical or different from each other, provided that the silicone compound contains at least two of said alkoxy groups per molecule; and m and n are both integers and satisfy m + n ≧ 1.)

5. The method for forming a metal pattern as recited in any one of claims 1 - 4, **characterized in that** a sequence of said steps are repeated to form plural superimposed metal patterns.

6. The method for forming a metal pattern as recited in any one of claims 1 - 5, **characterized in that** said electroless plating liquid contains a metal ion of copper, nickel, palladium, gold, platinum or rhodium which forms said metal film when deposited.

7. The method for forming a metal pattern as recited in any one of claims 1 - 6, **characterized in that** said metal having a lower standard electrode potential is gold, silver, platinum or palladium.

8. The method for forming a metal pattern as recited in any one of claims 1 - 6, **characterized in that** said metal having a lower standard electrode potential is palladium.
